# EUROPÄISCHE PATENTSCHRIFT

(11) **EP 3 679 169 B1**
(45) Veröffentlichungstag und Bekanntmachung des Hinweises auf die Patenterteilung: **16.06.2021**
(21) Anmeldenummer: 18765636.8
(22) Anmeldetag: 07.09.2018
(51) Int. Cl.: C23C 16/54, C23C 16/04, B65D 23/02, B65G 47/90, B65D 23/08

(54) **VORRICHTUNG ZUM BESCHICHTEN VON BEHÄLTERN MITTELS EINES BESCHICHTUNGSVERFAHRENS UND VERFAHREN ZUM BETRIEB EINER SOLCHEN VORRICHTUNG**
DEVICE FOR COATING CONTAINERS BY MEANS OF A COATING PROCESS AND METHOD FOR OPERATING SUCH A DEVICE
DISPOSITIF DE REVÊTEMENT DE RÉCIPIENTS AU MOYEN D'UN PROCÉDÉ DE REVÊTEMENT ET PROCÉDÉ D'UTILISATION D'UN TEL DISPOSITIF

(30) Priorität: 07.09.2017 DE 102017120650
(43) Veröffentlichungstag der Anmeldung: 15.07.2020
(73) Patentinhaber: KHS Corpoplast GmbH, 22145 Hamburg (DE)
(72) Erfinder: KYTZIA, Sebastian, 23826 Todesfelde (DE); KONRAD, Joachim, 40627 Düsseldorf (DE); HERBORT, Michael, 20535 Hamburg (DE)
(74) Vertreter: DTS Patent- und Rechtsanwälte Schnekenbühl und Partner mbB
(86) Internationale Anmeldenummer: PCT/EP2018/074076
(87) Internationale Veröffentlichungsnummer: WO 2019/048583

(56) Entgegenhaltungen:
- EP-A1- 1 336 667
- DE-A1- 10 234 374
- DE-A1-102010 008 387
- JP-A- 2017 071 505
- US-A- 4 022 155

## Beschreibung

Die vorliegende Erfindung betrifft eine Vorrichtung zum Beschichten von Behältern mittels eines Beschichtungsverfahrens, insbesondere eines CVD-Verfahrens, sowie Verfahren zum Betrieb einer solchen Vorrichtung.

Aus dem Stand der Technik bekannte Behälterbeschichtungsmaschinen werden unter anderem zum Beschichten der Innenflächen von Behältern, wie PET-Flaschen, verwendet. Bei solchen Anlagen werden die Behälter in einen Förderbereich eingefördert, von dort mittels einer Übergabevorrichtung zu einer Vorrichtung gebracht und an diese übergeben, mittels der ein Prozessgas in den Behälter eingebracht wird und somit seine Innenfläche beschichtet wird. Nach der erfolgten Beschichtung bringt die Übergabevorrichtung den Behälter wieder zurück in den Förderbereich. Von dort wird er ausgefördert und gelangt in die weitere Produktionskette.

Aus der DE 10 2010 023 119 A1 ist eine Vorrichtung zur Plasmabehandlung von Werkstücken bekannt, bei der das Werkstück in einer zumindest teilweise evakuierbaren Plasmakammer behandelt. Die Plasmakammer ist auf einem rotationsfähigen Plasmarad angeordnet, das eine Anzahl von Kavitäten aufweist, auf die die Werkstücke gesetzt werden, um die Behandlung vorzunehmen. Diese Kavitäten und die damit verbundenen Plasmastationen müssen mit dem Plasmarad mitgedreht werden. Die Beschickung des Plasmarades mit Werkstücken erfolgt nach einer Zuförderung der Werkstücke über ein Übergaberad und ein Eingaberad. Nach erfolgter Behandlung werden die Werkstücke vom Plasmarad an ein Ausgaberad übergeben. Von dort aus gelangt es in den Bereich einer Ausgabestrecke und wird abgefördert. Eine solche Ausgestaltung ist sehr aufwendig zu betreiben, da eine große Anzahl von Plasmastationen nötig ist, die auch noch mitdrehen müssen.

Aus der WO 2010/054206 A2 ist eine Vorrichtung für die Herstellung von Halbleiterbauelementen bekannt, die einen Haupttragrahmen aufweist, an dem unter anderem zwei Behandlungsstationen zur Bearbeitung jeweils eines einzelnen Substrats vorhanden sind. Die Substrate werden von einem an dem Haupttragrahmen befindlichen Behälter mittels eines Roboters in die Behandlungsstationen bewegt.

Aus der DE 199 22 873 A1 ist eine Vorrichtung zum Ein- und Ausbringen von Behältern in einen oder aus einem Behandlungsraum bekannt, in dem die Behälter beschichtet werde. Zwischen einem Zuförder/Abförderer und dem Behandlungsraum ist ein Schleusenrotor vorhanden, der Greif- und Halteeinrichtungen aufweist. Der Schleusenrotor bewegt die Behälter zwischen Zuförder/Abförderer und Behandlungsraum jeweils über ein zwischen ihm und dem Zuförderer/Abförderer einerseits und dem Behandlungsraum andererseits angeordnetes Sternradpaar, wobei jedes der Sternräder jeweils Greif- und Halteeinrichtungen aufweisen. Weiterer relevanter Stand der Technik wird in den Patentdokumenten US 4 022 155 A, JP 2017 071505 A und DE 102 34 374 A1 offenbart.

Es ist die Aufgabe der vorliegenden Erfindung, eine alternative Vorrichtung und ein Verfahren zum Plasmabeschichten von Behältern vorzustellen, welche die Nachteile des Standes der Technik überwinden.

Diese Aufgabe wird erfindungsgemäß durch eine Vorrichtung mit den Merkmalen des Patentanspruchs 1 gelöst. Danach ist vorgesehen, dass innerhalb des Haupttragrahmens eine Behandlungsstation zur Beschichtung der Behälter, eine Übergabevorrichtung, die die Behälter zwischen Fördervorrichtung und Behandlungsstation bewegt, vorhanden sind. Es ist auch mindestens eine Fördervorrichtung umfasst oder die vorgenannten Einheiten sind mit mindestens einer Fördervorrichtung verbindbar. Die Übergabevorrichtung weist eine Greifereinheit auf, die schwenkbar entlang einer parallel zur Fördervorrichtung ausgerichteten Schwenkachse an einem Greiferrahmen, der während des Betriebs der Vorrichtung ortsfest zum Haupttragrahmen angeordnet und/oder Teil des Haupttragrahmens ist, angebracht ist. Durch die Schwenkbewegung der Greifereinheit um die parallel zur Fördervorrichtung ausgerichtete Schwenkachse können an der Greifereinheit mehrere Greifer ausgebildet sein und es kommt bei einer Drehung der Behälter an den Greifern zu keiner Kollision der Behälter untereinander obwohl die Behälter in enger Nachbarschaft zueinander - wie sie von der Fördervorrichtung aufgenommen wurden - gedreht werden, im Gegensatz dazu, wenn eine Drehung der Behälter um eine zur Greiferlängsachse parallele Schwenkachsen durchgeführt würde. Dadurch, dass die Greifereinheit zwischen einer ersten Position, in der sie die Behälter im Bereich der Fördervorrichtung greifen kann, und einer zweiten Position, in der sie die Behälter in die Behandlungsstation einsetzen und aus dieser herausholen kann, bewegbareinschließlich einer Schwenkbewegung um die Schwenkachse - ist, kann eine gute und schnelle Überführung der unbehandelten Behälter von der Fördervorrichtung zur Behandlungsstation und nach der Behandlung der behandelten Behälter von der Behandlungsstation zur Fördervorrichtung erreicht werden.

Eine vorteilhafte Weiterbildung der Erfindung sieht vor, dass die Greifereinheit an einem mit dem Greiferrahmen verbundenen Schlitten angebracht ist und der Schlitten Linearbewegungen in drei senkrecht zueinander verlaufenden Richtungen ausführen kann. Dadurch kann die Greifereinheit auch dazu verwendet werden, mehrere Behandlungsstationen zu bedienen und sie ist flexibler einsetzbar, beispielsweise hinsichtlich der Bewegungskurve, die die Behälter bei der Überführung von der Fördervorrichtung zu einer Behandlungsstation machen.

Eine weitere vorteilhafte Weiterbildung der Erfindung sieht vor, dass die Fördervorrichtung zwei Teile, eine Einfördervorrichtung und eine Ausfördervorrichtung, aufweist und/oder die, eine erste Teilstation und eine zweite Teilstation, aufweist. Durch die Aufteilung der Fördervorrichtung ist ein getrennter Antrieb der Einfördervorrichtung und der Ausfördervorrichtung möglich, so dass diese nur dann angetrieben werden, wenn dies die aktuelle Situation erfordert. Somit kann die Entnahme der Behälter von der Einfördervorrichtung und die Rückgabe der Behälter an die Ausfördervorrichtung exakter erfolgen. Durch die Aufteilung der Behandlungsstation kann ein höherer Durchsatz erzielt werden, da die Behandlung in der einen Teilstation erfolgen kann, während die andere Teilstation beschickt oder entladen wird.

Eine weitere vorteilhafte Weiterbildung der Erfindung sieht vor, dass der Greiferrahmen samt daran angebrachter Übergabevorrichtung außerhalb des Betriebs gegenüber dem Haupttragrahmen absenkbar ist. Dadurch wird die Zugänglichkeit zu den einzelnen Komponenten der Beschichtungsvorrichtung verbessert, um beispielsweise Wartungsarbeiten einfacher durchführen zu können.

Eine weitere vorteilhafte Weiterbildung der Erfindung sieht vor, dass die Greifereinheit vier Greifer aufweist, die zueinander verfahrbar sind. Dadurch kann der Durchsatz erhöht werden, da gleichzeitig vier Behälter zwischen der Behandlungsstation und der Fördervorrichtung hin und her bewegt werden können. Dies gilt insbesondere in Verbindung mit der oben schon aufgeführten Aufteilung der Behandlungsstation in zwei separate Teilstationen.

Eine weitere vorteilhafte Weiterbildung der Erfindung sieht vor, der Abstand zwischen benachbarten Greifern axial zur Schwenkachse veränderbar ist. Dadurch ist es möglich, Behälter stark unterschiedlicher Größe ohne Modifikationen an dem Fördervorrichtung oder der Behandlungsstation vornehmen zu müssen, zu verarbeiten. Die Abstandsänderung ist bei solch verschieden großen Behältern notwendig, da der Abstand der Behandlungspositionen in der Behandlungsstation nur mit sehr großem Aufwand verändert werden könnte, aber der Abstand der Behälter regelmäßig beim Einlaufen auf der Fördervorrichtung bei stark unterschiedlicher Größe auch stark unterschiedlich ist. Dieser Größenunterschied wird bei der Bewegung von der Fördervorrichtung zur Behandlungsstation - dasselbe gilt auf dem Rückweg - ausgeglichen.

Eine weitere vorteilhafte Weiterbildung der Erfindung sieht vor, dass die Greifer entlang ihrer Längsachse bewegbar sind. Damit können auch Behandlungsstationen einfach mit Behältern bestückt werden, deren Behandlungspositionen nicht auf einer Geraden zueinander angeordnet sind, sondern sich auf einem Kreisliniensegment oder auch einer Kurve beliebiger Form befinden.

Eine weitere vorteilhafte Weiterbildung der Erfindung sieht vor, dass innerhalb des Haupttragrahmens der Vorrichtungen auch mindestens eine Fördervorrichtung mit mindestens einem Teilabschnitt vorhanden ist. Hierdurch können alle Strecken für den Überhub möglichst kurz gestaltet werden.

Eine weitere vorteilhafte Weiterbildung der Erfindung sieht vor, dass die Fördervorrichtung ein Geländer hat, bei dem mindestens der an seiner der Behandlungsstation zugewandten Seite angeordnete Teil absenkbar oder wegschwenkbar ist. Dadurch ist es nicht nötig, die Behälter nach dem Greifen durch die Greifereinheit zuerst ein ganzes Stück vertikal anzuheben und danach erst den Schwenkprozess einzuleiten - eventuell gefolgt von einer Linearbewegung der Übergabevorrichtung, die auch gleichzeitig mit dem Schwenkprozess durchgeführt werden kann. Damit wird neben der Vereinfachung des Bewegungsablaufs auch Zeit eingespart.

Die Aufgabe wird erfindungsgemäß auch durch ein Verfahren mit den Merkmalen des Patentanspruchs 10 gelöst. Danach ist vorgesehen, dass folgende Schritte mittels einer erfindungsgemäßen Vorrichtung durchgeführt werden:
a) Einfördern von Behältern durch die Fördervorrichtung;
b) Greifen von Behältern durch die Greifereinheit auf der Fördervorrichtung;
c) Anheben der Greifereinheit samt der Behälter;
d) Schwenken der Greifereinheit um die Schwenkachse;
e) lineares Verfahren der Greifereinheit bis sich die Behälter in der Behandlungsstation befinden;
f) Loslassen der Behälter durch die Greifereinheit;
g) Durchführung der Beschichtung;
h) Greifen der Behälter durch die Greifereinehit in der Behandlungsstation;
i) lineares Verfahren und Schwenken der Greifereinheit bis sich die Behälter über der Fördervorrichtung befinden;
j) Absetzen der Behälter auf der Fördervorrichtung und loslassen derselben durch die Greifereinheit;
k) Ausfördern der Behälter durch die Fördervorrichtung.

Dadurch werden die oben zu der erfindungsgemäßen Vorrichtung genannten Vorteile erzielt.

Eine vorteilhafte Weiterbildung des erfindungsgemäßen Verfahrens sieht vor, dass während der Schritte d und/oder e eine Änderung der Abstände zwischen benachbarten Greifern axial zur Schwenkachse erfolgt und diese Änderung während der Schritte i und/oder j rückgängig gemacht wird. Dadurch werden die oben zur Veränderbarkeit des axialen Abstands benachbarter Greifer bezogen auf die Schwenkachse erzielt.

Eine weitere vorteilhafte Weiterbildung des erfindungsgemäßen Verfahrens sieht vor, dass die Greifereinheit vier Greifer aufweist und die Abstandsänderung der beiden äußeren Greifer doppelt so schnell und weit erfolgt, wie diejenige der beiden inneren Greifer. Dadurch wird zum einen erreicht, dass die bewegten Behälter nicht aneinanderstoßen und die Abstände zwischen benachbarten Greifern am Ende des Vorgangs jeweils gleich groß sind.

Eine weitere vorteilhafte Weiterbildung des erfindungsgemäßen Verfahrens sieht vor, dass während der Schritte d und/oder e eine unterschiedliche Änderung der Abstände der Greifer von der Schwenkachse erfolgt und diese Änderung während der Schritte i und/oder j rückgängig gemacht wird. Dadurch werden die oben zur Bewegbarbarkeit der Greifer entlang ihrer Längsachse angegebenen Vorteile erreicht.

Eine weitere vorteilhafte Weiterbildung des erfindungsgemäßen Verfahrens sieht vor, dass das Schwenken der Greifereinheit um die Schwenkachse um 180° erfolgt. Dadurch werden die beim Einlauf auf der Förderrichtung stehenden Behälter - dort ist ihre Öffnung senkrecht nach oben ausgerichtet - so gedreht, dass ihre Öffnung senkrecht nach unten ausgerichtet ist. In einer solchen Ausrichtung kann die Beschichtung der Behälter mittels des Beschichtungsverfahrens gut durchgeführt werden.

Eine weitere vorteilhafte Weiterbildung des erfindungsgemäßen Verfahrens sieht vor, dass die Behandlungsstation, zwei separate Teilstationen, eine erste Teilstation und eine zweite Teilstation, aufweist und die Fördervorrichtung zwei Teile, eine Einfördervorrichtung und eine Ausfördervorrichtung, aufweist, wobei die Greifereinheit die Behälter immer von der Einfördervorrichtung entnimmt und sie immer auf der Ausfördervorrichtung absetzt und die Greifereinheit die Schritte b bis f oder h bis j bezogen auf die Teilstation durchführt, bei der gerade nicht Schritt g durchgeführt wird. Dadurch werden die oben zur Aufteilung der Fördervorrichtung angegebenen Vorteile erreicht.

Alle in den Unteransprüchen angegebenen Merkmale der vorteilhaften Weiterbildungen sind sowohl für sich jeweils einzeln als auch in beliebigen Kombinationen zur Erfindung gehörig.

Weitere Einzelheiten und Vorteile der Erfindung werden anhand von in den Zeichnungen dargestellten Ausführungsbeispielen näher erläutert.

Es zeigen:
- Figur 1: eine perspektivische Ansicht einer erfindungsgemäßen Übergabevorrichtung,
- Figur 2: eine perspektivische Ansicht eines zweiten Greifers aus Figur 1,
- Figur 3: eine perspektivische Ansicht eines ersten Greifers aus Figur 1,
- Figur 4: eine perspektivische Ansicht eines erfindungsgemäßen Greiferrahmens samt Schlitten und
- Figur 5: eine perspektivische Ansicht eine Fördervorrichtung.

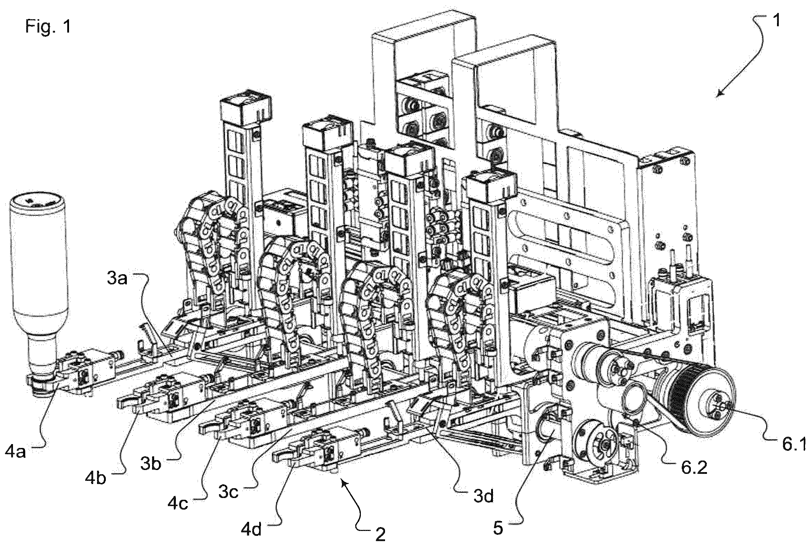

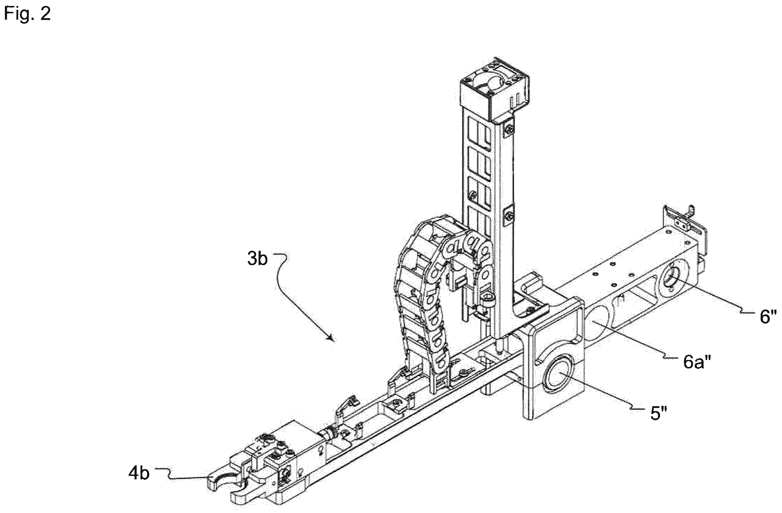

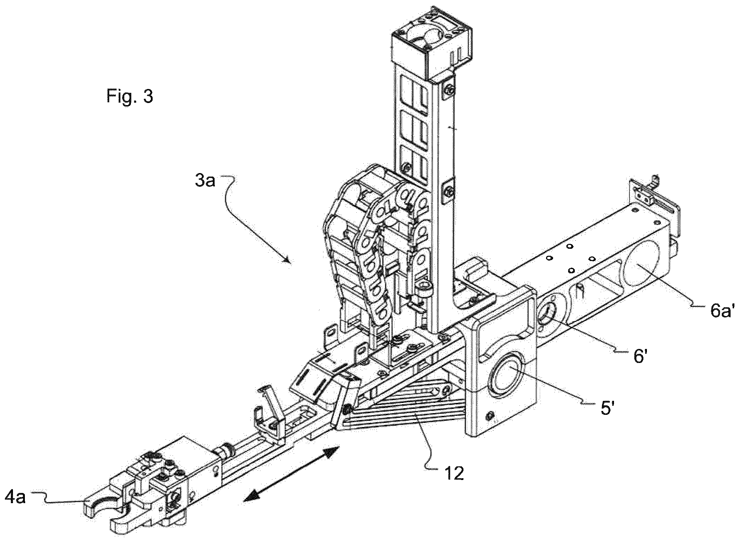

Figur 1 zeigt eine Übergabestation 1 mit einer Greifereinheit 2, die beispielhaft vier Greifer 3a, 3b, 3c, 3d umfasst, die im Wesentlichen in zwei verschiedenen Ausgestaltungen vorhanden sind: zwei äußere Greifer 3a, 3d (siehe Figur 3) und zwei innere Greifer 3b, 3c (siehe Figur 2). Jeder Greifer 3a, 3b, 3c, 3d weist an seinem Ende eine Greifzange 4a, 4b, 4c, 4d zum aktiven Greifen und Loslassen eines Behälters 17 (hier: eine PET-Flasche).

Die Greifer 3a, 3b, 3c, 3d sind um eine Schwenkachse 5 gegenüber dem Rest der Greifereinheit 2 schwenkbar. Näheres hierzu wird unten im Zusammenhang mit der Beschreibung der Figuren 2 und 3 noch ausgeführt. Dabei wäre rechts ein zu- bzw. ableitender Transporteur angeordnet und links die eigentliche Behandlungsstation. Die Figur 1 zeigt somit die Situation, dass Behälter 17 in Überkopflage unmittelbaren vor oder nach der Einstellung in die bzw. Entnahme aus der jeweiligen Beschichtungsstation.

Bei der Übernahme von stehend herangeführten Behältern 17, die beidseitig von einem Geländer 14 geführt werden, muss der Greifer 3a, 3b, 3c, 3d bzw. die Greifergruppe in der Regel die folgenden Bewegungsschritte durchlaufen: zum Überbrücken des inneren Führungsgeländers eine Hubbewegung, eine horizontale Rückzugsbewegung, ein vertikales Schwenken zur Überkopfstellung des Behälters 17, eine horizontale Vorschubbewegung, nötigenfalls eine vertikale Absenkbewegung zum Einstellen des Behälters 17 in die Behandlungsstation, eine Greiferöffnung und Rückzug des leeren Greifers 3a, 3b, 3c, 3d, damit die Behandlungsstation verschlossen werden kann. Die Rückführung von Behältern 17 aus der Behandlungsstation erfolgt dann in analoger Weise.

Es sind auch noch eine erste Längsverstellspindel 6.1 und eine zweite Längsverstellspindel 6.2 zu sehen, die dazu dienen, die Abstände zwischen den einzelnen Greifern 3a, 3b, 3c, 3d zu verändern. Hierzu wird die erste Längsverstellspindel 6.1 mittels eines Zahnriemens angetrieben. Über ein nicht gezeigtes Getriebe mit einer Übersetzung von 1:2 zwischen erster Längsverstellspindel 6.1 und zweiter Längsverstellspindel 6.2 wird die zweite Längsverstellspindel 6.2 mit doppelter Geschwindigkeit angetrieben. Näheres hierzu wird unten im Zusammenhang mit der Beschreibung der Figuren 2 und 3 noch ausgeführt.

In Figur 2 ist einer der beiden inneren Greifer 3b, 3c vergrößert und ohne den Rest der Greifereinheit 2 dargestellt; es handelt sich um den zweiten Greifer 3b. Dieser weist an seinem linken Ende die zweite Greifzange 4b auf, mit der er Behälter 17 (wie dies in Figur 1 dargestellt ist) greifen kann.

Die Schwenkbewegung des zweiten Greifers 3b erfolgt um die in Figur 1 dargestellte Schwenkachse 5, die durch eine Schwenkachsenhülse 5" greift. Der Antrieb für die Schwenkbewegung ist dem Fachmann bekannt und wird deshalb hier nicht beschrieben.

Rechts der Schwenkhülse 6" ist ein Bereich ausgebildet, der eine Änderung des Abstandes der Greifer 3a, 3b, 3c, 3d in axialer Richtung bezogen auf die Schwenkachse 5 ermöglicht. Hierfür sind eine zweite Öffnung 6a" und ein zweites Gewinde 6" vorhanden. Durch die erste Öffnung 6a" greift die zweite Längsverstellspindel 6.2 und durch das zweite Gewinde 6" greift die erste Längsverstellspindel 6.1 durch (beide Längsverstellspindeln 6.1, 6.2 sind in Figur 1 dargestellt). Die zweite Längsverstellspindel 6.2 hat Spiel in der zweiten Öffnung 6a" und wirkt deshalb nicht auf den zweiten Greifer 3b; aber die erste Längsverstellspindel 6.1 wirkt mit dem zweiten Gewinde 6" zusammen und bewirkt, dass der zweite Greifer 3b in Figur 1 nach links bewegt wird. Diese Bewegung erfolgt mit der Drehgeschwindigkeit der ersten Längsverstellspindel 6.1.

Der dritte Greifer 3c ist im Wesentlichen gleich ausgebildet wie der in Figur 2 dargestellte zweite Greifer 3b. Ein wesentlicher Unterschied besteht allerdings darin, dass anstelle des zweiten Gewindes 6" ein drittes Gewinde so ausgebildet ist, dass die Bewegung des dritten Greifers 3c in Figur 1 nach rechts mit derselben Geschwindigkeit wie der zweite Greifer 3b in die entgegengesetzte Richtung bewegt wird.

In Figur 3 ist einer der beiden äußeren Greifer 3a, 3d vergrößert (im gleichen Maßstab wie der zweite Greifer 3b in Figur 2) und ohne den Rest der Greifereinheit 2 dargestellt; es handelt sich um den ersten Greifer 3a. Dieser weist an seinem linken Ende die erste Greifzange 4a auf, mit der er Behälter 17 (wie dies in Figur 1 dargestellt ist) greifen kann.

Auch die Schwenkbewegung des ersten Greifers 3a erfolgt um die in Figur 1 dargestellte Schwenkachse 5, die durch eine Schwenkachsenhülse 5' greift. Der Antrieb für die Schwenkbewegung ist dem Fachmann bekannt und wird deshalb hier nicht beschrieben.

Der erste Greifer 3a weist zwei signifikante Unterschiede zu dem zweiten Greifer 3b auf.

Der erste Unterschied besteht darin, dass die Anordnung von Öffnung und Gewinde vertauscht gegenüber dem zweiten Greifer 3b ist: Wo beim zweiten Greifer 3b die zweite Öffnung 6a" war, ist beim ersten Greifer 3a ein erstes Gewinde 6' und wo das zweite Gewinde 6" war, ist eine erste Öffnung 6a'. Dies bedeutet, dass die erste Längsverstellspindel 6.1 nicht mit dem ersten Greifer 3a zusammenwirkt, sie durchgreift diesen vielmehr spielbehaftet. Aber die zweite Längsverstellspindel 6.2 wirkt mit dem ersten Greifer 3a übe das erste Gewinde 6' so zusammen, dass der erste Greifer 3a in Figur 1 nach links bewegt wird. Diese Bewegung erfolgt mit der doppelten Drehgeschwindigkeit verglichen mit der ersten Längsverstellspindel 6.1, da die zweite Längsverstellspindel 6.2 über das oben beschriebene Getriebe die doppelte Drehgeschwindigkeit aufweist. Dadurch ist der Abstand des ersten Greifers 3a zum Mittelpunkt zwischen zweitem Greifer 3b und drittem Greifer 3c immer doppelt so groß wie der Abstand des zweiten Greifers (dasselbe gilt aufgrund der obigen Ausführungen auch für den dritten Greifer 3c) zu diesem Mittelpunkt. Damit ergibt sich, dass der Abstand des ersten Greifers 3a vom zweiten Greifer 3b immer gleich groß ist, wie der Abstand des zweiten Greifers 3b vom dritten Greifer 3c.

Für den vierten Greifer 3d gilt im Wesentlichen, dass er die gleiche Abwandlung vom ersten Greifer 3a aufweist, wie der dritte Greifer 3c vom zweiten Greifer 3b: sein viertes Gewinde - das anstelle des ersten Gewindes an ihm ausgebildet ist - ist so ausgebildet, dass eine Bewegung des vierten Greifers 3d in die entgegengesetzte Richtung erfolgt, wie diejenige des ersten Greifers 3a - also in Figur 1 nach rechts. Damit ergibt sich auch, dass der Abstand des vierten Greifers 3d vom dritten Greifer 3c immer gleich groß ist, wie der Abstand des zweiten Greifers 3b vom dritten Greifer 3c. Somit haben jeweils benachbarte Greifer 3a, 3b, 3c, 3d immer denselben Abstand zueinander.

Durch diese einfache, synchronisierte Abstandsänderung ist wird zum einen vermieden, dass die Behälter 17 bei der Schwenkbewegung aneinander schlagen können und zum anderen ist es dadurch möglich, Behälter 17 stark unterschiedlicher Größe ohne Modifikationen an der Fördervorrichtung 13 oder der Behandlungsstation vornehmen zu müssen, zu verarbeiten. Die Abstandsänderung ist insbesondere bei der Bearbeitung verschieden großer Behälter 17 notwendig, da der Abstand der Behandlungspositionen in der Behandlungsstation nur mit sehr großem Aufwand verändert werden könnte, aber der Abstand der Behälter 17 regelmäßig beim Einlaufen auf der Fördervorrichtung 13 bei stark unterschiedlicher Größe auch stark unterschiedlich ist. Dieser Größenunterschied wird bei der Bewegung von der Fördervorrichtung 13 zur Behandlungsstation - dasselbe gilt auf dem Rückweg - ausgeglichen.

Ein weiterer signifikanter Unterschied des ersten Greifers 3a zum zweiten Greifer 3b besteht darin, dass er entlang seiner Längsachse längenveränderlich ist; dies wird in Figur 3 anhand eines Doppelpfeils verdeutlicht. Die Längenveränderlichkeit wird dadurch erreicht, dass zwischen dem Teil, in dem die Schwenkachsenhülse 5' ausgebildet ist und dem in Figur 3 horizontal nach links weisenden Teil, an dem am vorderen Ende die erste Greifzange 4a angeordnet ist, eine Zugstange 12 angeordnet ist, die mit entsprechenden mechanischen Bestandteilen an den beiden genannten Teilen so zusammenwirkt, dass die genannte Längenveränderung des ersten Greifers 3a erfolgt. Solche Mechaniken sind dem Fachmann bekannt. Aufgrund der Längenänderung bewegt sich die erste Greifzange 4a parallel zum Doppelfeil entlang der Längsachse des ersten Greifers 3a.

Der vierte Greifer 3d weist eine im Wesentlichen gleiche Vorrichtung zur Längenänderung entlang seiner Längsachse auf, wie diejenige des ersten Greifers 4a. Somit befinden sich die Greifzangen 4a, 4b, 4c, 4d nicht auf einer Geraden, sondern auf einem Kreisliniensegment. Damit können auch Behandlungsstationen einfach mit Behältern 17 bestückt werden, deren Behandlungspositionen nicht auf einer Geraden zueinander angeordnet sind, sondern sich auf einem Kreisliniensegment befinden.

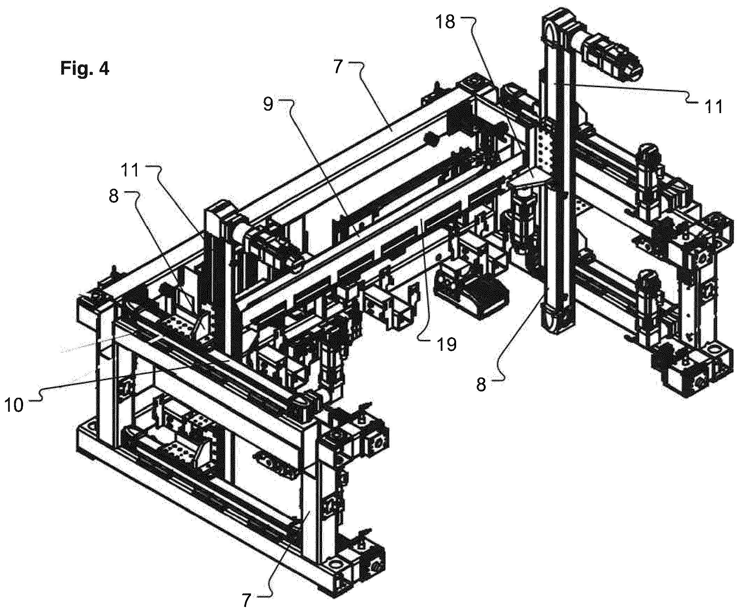

In Figur 4 ist ein Greiferrahmen 7 mit daran angebrachtem Schlitten 8 in verkleinertem Maßstab dargestellt. Die Übergabevorrichtung 1 ist hingegen nicht an der dargestellten Vorrichtung montiert. Sie würde an einem Träger 19 befestigt, der die X-Achse 9 des Schlittens 8 definiert und sich in der Horizontalen erstreckt.

Der Greiferrahmen 7 weist zwei U-förmige Trägeranordnungen auf, die horizontal ausgerichtet und vertikal übereinander angeordnet sind. Diese sind über vertikale Streben miteinander fest verbunden.

An diesem sehr stabilen Greiferrahmen 7 ist der Schlitten 8 so angebracht, dass er innerhalb des Greiferrahmens 7 bewegbar ist. Er lässt Bewegungen der Übergabevorrichtung 1 nach deren Montage an ihm entlang der X-Achse 9, einer dazu sich ebenfalls in der Horizontalen sicher erstreckenden Y-Achse 10 sowie einer dazu senkrechten, in der Vertikalen verlaufenden Z-Achse 11 zu. Hinzu kommt noch die Möglichkeit der Übergabevorrichtung 1, um die Schwenkachse 5, die parallel zur X-Achse 9 ausgerichtet ist, zu schenken. Desweitern sind auch noch die beiden äußeren Greifer 3a, 3d entlang ihrer jeweiligen Längsachse längenveränderlich. Schließlich ist auch noch der Abstand der Greifer 3a, 3b, 3c, 3d zueinander entlang der Schwenkachse 5 veränderlich.

Aufgrund dieser mannigfaltigen Bewegungsmöglichkeiten, können von der Übergabevorrichtung 1 von der Fördervorrichtung 13 aufgenommene Behälter 17 schnell, sicher und flexibel zu einer Behandlungsstation gebracht werden, dort beschichtet werden und dann wieder auf der Fördervorrichtung 13 abgesetzt werden. Die konkret oben in dem Teil mit der allgemeinen Beschreibung und den Patentansprüchen genannten Verfahrensschritte können mit einer solchen Vorrichtung sehr gut durchgeführt werden. Die Behandlungsstation ist in Figur 4 nicht dargestellt befindet sich aber im Bereich der zwischen den freien Schenkeln des U-förmigen Greiferrahmens 7, so dass sie gut für die Greifer 3a, 3b, 3c, 3d erreichbar sind, um dort die Behälter 17 für die Beschichtung einzubringen und nach erfolgter Beschichtung wieder abzuholen.

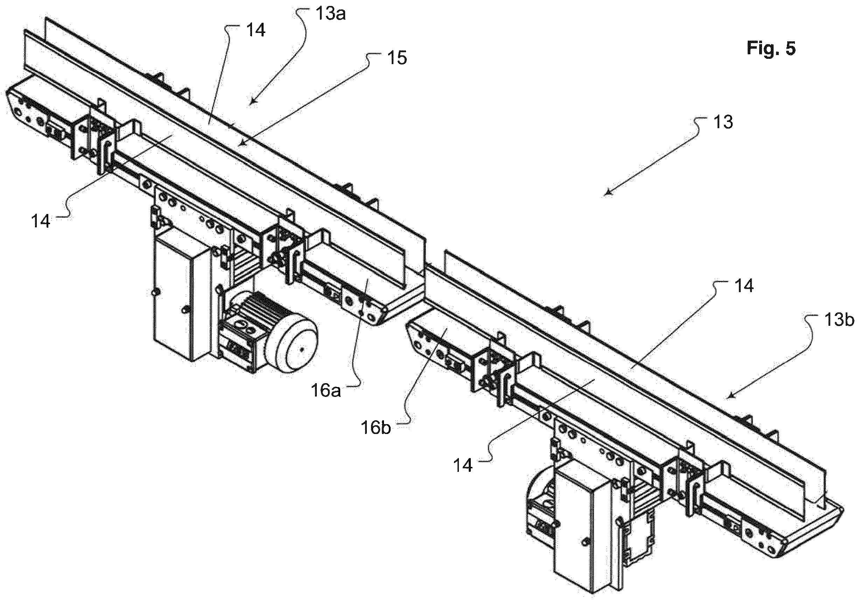

In Figur 5 ist - nicht maßstabsgetreu - eine Fördervorrichtung 13 dargestellt, die sich im eingebauten Zustand mindestens mit einer Teillänge innerhalb des nicht dargestellten Hauptrahmens und parallel zur X-Achse 9 zwischen dem Träger 19 des Schlittens 8 und dem mittleren Träger des U-förmigen Greiferrahmens 7 (der in Figur 1 schräg von links unten nach rechts oben verlaufend ganz links zu sehen ist) befindet. Diese Fördervorrichtung 13 kann insgesamt oder mindestens mit einer Teillänge integraler Bestandteil der Beschichtungsmaschine oder beispielsweise unmittelbar vor Kopf im Wirkbereich der Greifer 3a, 3b, 3c, 3d angeordnet sein.

Diese Fördervorrichtung 13 ist zweigeteilt. Sie ist aufgeteilt in eine Einfördervorrichtung 13a mit einem ersten Förderband 16a und eine Ausfördervorrichtung 13b mit einem zweiten Förderband 16b, wobei die beiden Förderbänder 16a, 16b unabhängig voneinander bewegbar sind. Über jedem Förderband 16a, 16b ist jeweils eine Gasse 15 vorhanden, die durch jeweils zwei senkrecht nach oben stehende Geländer 14 gebildet wird. Die Abstände zwischen den Geländern 14 sind veränderbar, so dass die Breite der Gasse 14 variiert werden kann und auf die Größe der zu behandelnden Behälter 17 eingestellt werden kann, so dass deren Vorwärtsbewegung nur mit wenig Spiel zwischen den Geländern 14 erfolgt. Dadurch wird verhindert, dass die Behälter 17 umfallen können.

Das zur Übergabevorrichtung 1 zugewandte Geländer 14 kann in einer anderen Ausführungsform abgesenkt oder weggeklappt werden. Dadurch ist es nach dem Aufnehmen der Behälter 17 durch die Greifereinheit 2 nur minimal nötig, die Übergabevorrichtung 1 nach oben (entlang der Z-Achse 11) zu verfahren; ein weites nach oben Fahren, um sie aus der Gasse 15 herauszuheben ist nicht nöig und es wird zeit eingespart.

Nachdem die Behälter 17 behandelt wurden und weiter in der Produktionslinie voranschreiten sollen, müssen sie auf dem zweiten Förderband 16b der Ausfördervorrichtung 13b abgesetzt werden. Während des Abstellvorgangs kann das zweite Förderband 16b angehalten werden, obwohl das erste Förderband 16a weiter läuft und weitere Behälter 17 einfördert. Durch das Anhalten wird verhindert, dass Behälter 17 beim Absetzen auf einem laufenden zweiten Förderband 16b umfallen können.

Die vorstehend ausgeführte Antriebsvariante der Greifer 3a, 3b, 3c, 3d ist sehr kostengünstig und effektiv. Alternativ kann auf für jeden Greifer 3a, 3b, 3c, 3d zur Querverstellung zueinander auf jedem Greifer 3a, 3b, 3c, 3d eine Einzelantrieb mit geeigneter Steuerung vorgesehen werden, so dass jeder Greifer 3a, 3b, 3c, 3d unabhängig von den anderen quer bewegt werden kann.

Dies können beispielweise Servomotoren sein, die als Außenläufermotoren ausgebildet sind und die beispielsweise auf einer gemeinsamen Spindel laufen. Alternativ kann auch ein elektromagnetischer Direktantrieb vorgesehen werden, bei dem jeder Greifer 3a, 3b, 3c, 3d auf einem Bewegungsschlitten geträgert ist und mit diesem Verfahren wird, wobei jeder Bewegungsschlitten unabhängig von den anderen steuer- und regelbar ist, wobei idealerweise der querlaufende Träger auch den Stator und Antrieb bildet.
Weiterhin ist die Anzahl von vier Greifern einer Gruppe natürlich nur eine Ausführungsvariante. Vorteilhafterweise wird eine Gruppen mit zwei bis 12 Greifern versehen, je nach Anzahl der Behandlungsstationen oder Formatvielfalt der zu behandelnden Behälter.

### Bezugszeichenliste

- 1: Übergabevorrichtug
- 2: Greifereinheit
- 3a: erster Greifer
- 3b: zweiter Greifer
- 3c: dritter Greifer
- 3d: vierter Greifer
- 4a: erste Greifzange
- 4b: zweite Greifzange
- 4c: dritte Greifzange
- 4d: vierte Greifzange
- 5: Schwenkachse
- 5', 5": Schwenkachsenhülse
- 6.1: erste Längsverstellspindel
- 6.2: zweite Längsverstellspindel
- 6': erstes Gewinde für Längsverstellspindel
- 6": zweites Gewinde für Längsverstellspindel
- 6a': erste Öffnung für Längsverstellspindel
- 6a": zweite Öffnung für Längsverstellspindel
- 7: Greiferrahmen
- 8: Schlitten
- 9: X-Achse
- 10: Y-Achse
- 11: Z-Achse
- 12: Zugstange
- 13: Fördervorrichtung
- 13a: Einfördervorrichtung
- 13b: Ausfördervorrichtung
- 14: Geländer
- 15: Gasse
- 16a: erstes Förderband
- 16b: zweites Förderband
- 17: Behälter
- 18: Halterung
- 19: Träger

## Patentansprüche

1. Vorrichtung zum Beschichten von Behältern (17) mittels eines Beschichtungsverfahrens,
mit einem Haupttragrahmen,
wobei innerhalb des Haupttragrahmens folgende Einheiten vorhanden sind:
- eine Behandlungsstation zur Beschichtung der Behälter (17),
- eine Übergabevorrichtung (1), die die Behälter (17) zwischen mindestens einer Fördervorrichtung (13) und Behandlungsstation bewegt,
wobei die Einheiten auch die mindestens eine Fördervorrichtung (13) umfassen oder mit der mindestens einen Fördervorrichtung (13) verbindbar sind,
wobei die Übergabevorrichtung (1) eine Greifereinheit (2) aufweist, die schwenkbar entlang einer parallel zur Fördervorrichtung (13) ausgerichteten Schwenkachse (5) an einem Greiferrahmen (7), der während des Betriebs der Vorrichtung ortsfest zum Haupttragrahmen angeordnet und/oder Teil des Haupttragrahmens ist, angebracht ist,
wobei die Greifereinheit (2) zwischen einer ersten Position, in der sie die Behälter (17) im Bereich der Fördervorrichtung (13) greifen kann, und einer zweiten Position, in der sie die Behälter (17) in die Behandlungsstation einsetzen und aus dieser herausholen kann, bewegbar ist.

2. Vorrichtung nach Patentanspruch 1, wobei die Greifereinheit (2) an einem mit dem Greiferrahmen (7) verbundenen Schlitten (8) angebracht ist und der Schlitten (8) Linearbewegungen in drei senkrecht zueinander verlaufenden Richtungen ausführen kann.

3. Vorrichtung nach einem der vorstehenden Patentansprüche, wobei die Fördervorrichtung (13) zwei Teile, eine Einfördervorrichtung (13a) und eine Ausfördervorrichtung (13b), aufweist und/oder die Behandlungsstation, zwei separate Teilstationen, eine erste Teilstation und eine zweite Teilstation, aufweist.

4. Vorrichtung nach einem der vorstehenden Patentansprüche, wobei der Greiferrahmen (7) samt daran angebrachter Übergabevorrichtung (1) außerhalb des Betriebs gegenüber dem Haupttragrahmen absenkbar ist.

5. Vorrichtung nach einem der vorstehenden Patentansprüche, wobei die Greifereinheit (2) eine Gruppe von Greifern (3a, 3b, 3c, 3d) aufweist, die zueinander verfahrbar sind, insbesondere eine Gruppe von 2 bis 12 Greifern.

6. Vorrichtung nach Patentanspruch 4, wobei der Abstand zwischen benachbarten Greifern (3a, 3b, 3c, 3d) axial zur Schwenkachse (5) veränderbar ist.

7. Vorrichtung nach Patentanspruch 4 oder 5, wobei die Greifer (3a, 3b, 3c, 3d) entlang ihrer Längsachse bewegbar sind.

8. Vorrichtung nach einem der vorstehenden Patentansprüche, wobei innerhalb des Haupttragrahmens der Vorrichtungen auch mindestens eine Fördervorrichtung (13) mit mindestens einem Teilabschnitt vorhanden ist.

9. Vorrichtung nach einem der vorstehenden Patentansprüche, wobei die Fördervorrichtung (13) ein Geländer (14) hat, bei dem mindestens der an seiner der Behandlungsstation zugewandten Seite angeordnete Teil absenkbar oder wegschwenkbar ist.

10. Verfahren zum Betrieb einer Vorrichtung nach einem der vorstehenden Patentansprüche mit folgenden Schritten:
a) Einfördern von Behältern (17) durch die Fördervorrichtung (13);
b) Greifen von Behältern (17) durch die Greifereinheit (2) auf der Fördervorrichtung (13);
c) Anheben der Greifereinheit (2) samt der Behälter (17);
d) Schwenken der Greifereinheit (2) um die Schwenkachse (5);
e) lineares Verfahren der Greifereinheit (2) bis sich die Behälter (17) in der Behandlungsstation befinden;
f) Loslassen der Behälter (17) durch die Greifereinheit (2);
g) Durchführung der Beschichtung;
h) Greifen der Behälter (17) durch die Greifereinehit (2) in der Behandlungsstation;
i) lineares Verfahren und Schwenken der Greifereinheit (2) bis sich die Behälter (17) über der Fördervorrichtung (13) befinden;
j) Absetzen der Behälter (17) auf der Fördervorrichtung (13) und loslassen derselben durch die Greifereinheit (2);
k) Ausfördern der Behälter (17) durch die Fördervorrichtung (13).

11. Verfahren nach Patentanspruch 10, wobei während der Schritte d und/oder e eine Änderung der Abstände zwischen benachbarten Greifern (3a, 3b, 3c, 3d) axial zur Schwenkachse (5) erfolgt und diese Änderung während der Schritte i und/oder j rückgängig gemacht wird.

12. Verfahren nach Patentanspruch 11, wobei die Greifereinheit vier Greifer (3a, 3b, 3c, 3d) aufweist und die Abstandsänderung der beiden äußeren Greifer (3a, 3d) doppelt so schnell und weit erfolgt, wie diejenige der beiden inneren Greifer (3b, 3c).

13. Verfahren nach Patentanspruch 10 oder 11, wobei während der Schritte d und/oder e eine unterschiedliche Änderung der Abstände der Greifer (3a, 3b, 3c, 3d) von der Schwenkachse (5) erfolgt und diese Änderung während der Schritte i und/oder j rückgängig gemacht wird.

14. Verfahren nach einem der Patentansprüche 10 bis 13, wobei das Schwenken der Greifereinheit (2) um die Schwenkachse (5) um 180° erfolgt.

15. Verfahren nach einem der Patentansprüche 10 bis 14, wobei die Behandlungsstation, zwei separate Teilstationen, eine erste Teilstation und eine zweite Teilstation, aufweist und die Fördervorrichtung (13) zwei Teile, eine Einfördervorrichtung (13a) und eine Ausfördervorrichtung (13b), aufweist, wobei die Greifereinheit (2) die Behälter immer von der Einfördervorrichtung (13a) entnimmt und sie immer auf der Ausfördervorrichtung (13b) absetzt und die Greifereinheit (2) die Schritte b bis f oder h bis j bezogen auf die Teilstation durchführt, bei der gerade nicht Schritt g durchgeführt wird.

## Claims

1. Device for coating containers (17) by means of a coating process,
with a main supporting frame,
wherein the following units are present inside the main supporting frame:
- a treatment station for coating the containers (17),
- a transfer device (1), which moves the containers (17) between at least one conveying device (13) and treatment station,
wherein the units also comprise the at least one conveying device (13) or can be connected to the at least one conveying device (13),
wherein the transfer device (1) has a gripper unit (2), which is mounted pivotably along a pivot axis (5) aligned parallel to the conveying device (13) on a gripper frame (7), which is arranged fixed in place in relation to the main supporting frame during the operation of the device and/or is part of the main supporting frame,
wherein the gripper unit (2) can be moved between a first position, in which it can grip the containers (17) in the region of the conveying device (13), and a second position, in which it can insert the containers (17) into the treatment station and fetch them from it.

2. Device according to claim 1, wherein the gripper unit (2) is mounted on a carriage (8) connected to the gripper frame (7) and the carriage (8) can perform linear movements in three directions running perpendicular to one another.

3. Device according to one of the preceding claims, wherein the conveying device (13) has two parts, an inlet conveying device (13a) and an outlet conveying device (13b), and/or the treatment station has two separate part stations, a first part station and a second part station.

4. Device according to one of the preceding claims, wherein, when not in operation, the gripper frame (7) together with the transfer device (1) mounted on it can be lowered in relation to the main supporting frame.

5. Device according to one of the preceding claims, wherein the gripper unit (2) has a group of grippers (3a, 3b, 3c, 3d) which can be moved towards one another, in particular a group of 2 to 12 grippers.

6. Device according to claim 4, wherein the distance between adjacent grippers (3a, 3b, 3c, 3d) can be changed axially relative to the pivot axis (5).

7. Device according to claim 4 or 5, wherein the grippers (3a, 3b, 3c, 3d) can be moved along their longitudinal axis.

8. Device according to one of the preceding claims, wherein, inside the main supporting frame of the devices, there is also at least one conveying device (13) present with at least one part section.

9. Device according to one of the preceding claims, wherein the conveying device (13) has a rail (14), by which at least the part arranged on its side facing towards the treatment station can be lowered or pivoted away.

10. Method for operating a device according to one of the preceding claims, with the following steps:
a) inlet conveying of containers (17) by the conveying device (13);
b) gripping of containers (17) by the gripper unit (2) on the conveying device (13);
c) raising the gripper unit (2) together with the containers (17);
d) pivoting the gripper unit (2) about the pivot axis (5);
e) linear moving of the gripper unit (2) until the containers (17) are located in the treatment station;
f) releasing the containers (17) by the gripper unit (2);
g) carrying out the coating;
h) gripping the containers (17) by the gripper unit (2) in the treatment station;
i) linear moving and pivoting of the gripper unit (2) until the containers (17) are located above the conveying device (13);
j) setting the containers (17) down on the conveying device (13) and releasing them by the gripper unit (2);
k) outlet conveying of the containers (17) by the conveying device (13).

11. Method according to claim 10, wherein, during steps d and/or e, a change in the distances between adjacent grippers (3a, 3b, 3c, 3d) is effected axially relative to the pivot axis (5) and this change is reversed during steps i and/or j.

12. Method according to claim 11, wherein the gripper unit has four grippers (3a, 3b, 3c, 3d) and the change in the distance between the two outer grippers (3a, 3d) is effected twice as rapidly and twice as far as that of the two inner grippers (3b, 3c).

13. Method according to claim 10 or 11, wherein, during steps d and/or e, a different change in the distances of the grippers (3a, 3b, 3c, 3d) from the pivot axis (5) is effected and this change is reversed during steps i and/or j.

14. Method according to one of claims 10 to 13, wherein the pivoting of the gripper unit (2) about the pivot axis (5) takes place through 180°.

15. Method according to one of claims 10 to 14, wherein the treatment station has two separate part stations, a first part station and a second part station, and the conveying device (13) has two parts, an inlet conveying device (13a) and an outlet conveying device (13b), wherein the gripper unit (2) always takes the containers from the inlet conveying device (13a) and always sets them down on the outlet conveying device (13b), and the gripper unit (2) carries out steps b to f or h to j based on the part station, whereby step g is specifically not carried out.

## Revendications

1. Dispositif de revêtement de récipients (17) à l'aide d'un procédé de revêtement ;
avec un châssis porteur principal ;
les unités suivantes étant présentes à l'intérieur du châssis porteur principal :
- une station de traitement pour le revêtement des récipients (17) ;
- un dispositif de transfert (1) transférant les récipients (17) entre au moins un dispositif de transport (13) et la station de traitement ;
les unités comprenant également l'au moins un dispositif de transport (13) ou pouvant être reliées à l'au moins un dispositif de transport (13) ;
le dispositif de transfert (1) comportant une unité de préhension (2) disposée de façon à pouvoir pivoter le long d'un axe de pivotement (5) orienté parallèlement au dispositif de transport (13) au niveau d'un châssis de préhension (7) disposé fixement sur place par rapport au châssis porteur principal pendant le fonctionnement du dispositif et/ou faisant partie du châssis porteur principal ;
l'unité de préhension (2) pouvant être déplacée entre une première position dans laquelle elle peut agripper les récipients (17) dans la région du dispositif de transport (13) et une deuxième position dans laquelle elle peut placer les récipients (17) dans la station de traitement et les en retirer.

2. Dispositif selon la revendication 1, l'unité de préhension (2) étant disposée au niveau d'un coulisseau (8) relié au châssis de préhension (7) et le coulisseau (8) pouvant réaliser des mouvements linéaires dans trois directions s'étendant perpendiculairement les unes par rapport aux autres.

3. Dispositif selon l'une quelconque des revendications précédentes, le dispositif de transport (13) comportant deux parties, un dispositif de transport entrant (13a) et un dispositif de transport sortant (13b) et/ou la station de traitement comportant deux stations partielles séparées, une première station partielle et une deuxième station partielle.

4. Dispositif selon l'une quelconque des revendications précédentes, le châssis de préhension (7) ainsi que l'ensemble du dispositif de transfert (1) afférant pouvant être descendu en dehors de tout fonctionnement par rapport au châssis porteur principal.

5. Dispositif selon l'une quelconque des revendications précédentes, l'unité de préhension (2) comportant un groupe de grappins (3a, 3b, 3c, 3d) pouvant être déplacés les uns par rapport aux autres, notamment un groupe de 2 à 12 grappins.

6. Dispositif selon la revendication 4, la distance entre des grappins (3a, 3b, 3c, 3d) voisins pouvant varier dans le plan axial par rapport à un axe de pivotement (5).

7. Dispositif selon la revendication 4 ou 5, les grappins (3a, 3b, 3c, 3d) pouvant être déplacés le long de leur axe longitudinal.

8. Dispositif selon l'une quelconque des revendications précédentes, au moins un dispositif de transport (13) avec au moins une section partielle étant également présent à l'intérieur du châssis porteur principal des dispositifs.

9. Dispositif selon l'une quelconque des revendications précédentes, le dispositif de transport (13) ayant une rampe (14) dans lequel au moins la partie disposée au niveau de son côté orienté vers la station de traitement peut pivoter de façon à pouvoir être descendue ou éloignée.

10. Procédé de fonctionnement d'un dispositif selon l'une quelconque des revendications précédentes avec les étapes suivantes :
a) amenée de récipients (17) par le biais du dispositif de transport (13) ;
b) préhension de récipients (17) par le biais de l'unité de préhension (2) sur le dispositif de transport (13) ;
c) soulèvement de l'unité de préhension (2) conjointement avec les récipients (17) ;
d) pivotement de l'unité de préhension (2) autour de l'axe de pivotement (5) ;
e) déplacement linéaire de l'unité de préhension (2) jusqu'à ce que les récipients (17) se trouvent dans la station de traitement ;
f) libération des récipients (17) par l'unité de préhension (2) ;
g) mise en œuvre du revêtement ;
h) préhension des récipients (17) par l'unité de préhension (2) dans la station de traitement ;
i) déplacement linéaire et pivotement de l'unité de préhension (2) jusqu'à ce que les récipients (17) se trouvent au-dessus du dispositif de transport (13) ;
j) dépôt des récipients (17) sur le dispositif de transport (13) et libération de ceux-ci par l'unité de préhension (2) ;
k) sortie des récipients (17) par le dispositif de transport (13).

11. Procédé selon la revendication 10, un changement des distances entre grappins (3a, 3b, 3c, 3d) connexes se produisant dans le plan axial pendant les étapes d et/ou e par rapport à l'axe de pivotement (5) et ce changement étant rendu rétrograde aux étapes i et/ou j.

12. Procédé selon la revendication 11, l'unité de préhension comportant quatre grappins (3a, 3b, 3c, 3d) et le changement de distance des deux grappins extérieurs (3a, 3d) s'effectuant deux fois plus vite que celui des deux grappins intérieurs (3b, 3c).

13. Procédé selon la revendication 10 ou 11, un changement différent des distances des grappins (3a, 3b, 3c, 3d) étant réalisé pendant les étapes d et/ou e depuis l'axe de pivotement (5) et ce changement étant rendu rétrograde pendant les étapes i et/ou j.

14. Procédé selon l'une quelconque des revendications 10 à 13, le pivotement de l'unité de préhension (2) se produisant sur 180° autour de l'axe de pivotement (5).

15. Procédé selon l'une quelconque des revendications 10 à 14, la station de traitement comportant deux stations partielles séparées, une première station partielle et une deuxième station partielle et le dispositif de transport (13) comportant deux parties, un dispositif de transport entrant (13a) et un dispositif de transport sortant (13b), l'unité de préhension (2) retirant toujours les récipients du dispositif de transport entrant (13a) et les plaçant toujours sur le dispositif de transport sortant (13b) et l'unité de préhension (2) effectuant les étapes b à f ou h à j pour la station partielle n'effectuant pas l'étape g.
